(19) Europäisches Patentamt
European Patent Office
Office européen des brevets

(11) **EP 4 683 031 A2**

(12) **EUROPEAN PATENT APPLICATION**

(43) Date of publication:
**21.01.2026 Bulletin 2026/04**

(21) Application number: **25184865.1**

(22) Date of filing: **24.06.2025**

(51) International Patent Classification (IPC):
**H01M 10/42** (2006.01)     **G01R 31/367** (2019.01)
**G01R 31/389** (2019.01)     **H01M 10/48** (2006.01)

(52) Cooperative Patent Classification (CPC):
**Y02E 60/10**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **28.06.2024 CN 202410866661**

(71) Applicant: **Eve Energy Co., Ltd.**
**Huizhou, Guangdong 516006 (CN)**

(72) Inventors:
• **KANG, Zhenhua**
  **Huizhou (CN)**
• **LING, Xinchen**
  **Huizhou (CN)**
• **WAN, Liping**
  **Huizhou (CN)**

(74) Representative: **Herrero & Asociados, S.L.**
**Edificio Aqua - Calle Agustín de Foxá, 4-10, 2ºA**
**28036 Madrid (ES)**

(54) **METHOD AND SYSTEM FOR PREDICTING BATTERY THERMAL RUNAWAY, AND STORAGE MEDIUM**

(57)     A method and a system for predicting battery thermal runaway, and a storage medium are provided. The method includes: obtaining voltage data of a battery to be tested under a preset condition; obtaining internal resistance data of the battery to be tested according to the preset condition and voltage data; processing the internal resistance data based on a preset activation energy model to obtain activation energy data of the battery to be tested; and determining a thermal runaway probability of the battery to be tested according to the activation energy data, thereby achieving accurate prediction of thermal runaway of the battery to be tested.

S210
Obtaining voltage data of a battery to be tested under a preset condition

S220
Obtaining internal resistance data of the battery to be tested according to the preset condition and the voltage data

S230
Processing the internal resistance data based on a preset activation energy model to obtain activation energy data of the battery to be tested

S240
Determining a thermal runaway probability of the battery to be tested according to the activation energy data

FIG. 2

EP 4 683 031 A2

**Description**

**TECHNICAL FIELD**

The present disclosure relates to the field of battery technologies, and in particular, to a method and a system for predicting battery thermal runaway, and a storage medium.

**BACKGROUND**

Batteries are the main energy output source and energy storage devices for an electrical devices. For example, batteries can serve as a power sources and energy carriers of new energy vehicles, and undertake functions such as vehicle acceleration, vehicle speed maintenance, and energy recovery. Battery thermal runaway refers to a phenomenon in which the current and temperature undergo a cumulative enhancement during a charging or discharging process of the battery, causing the battery temperature to rise rapidly, which may eventually cause battery damage, fire or explosion. Therefore, it is necessary to predict battery thermal runaway and remind users to detect and replace the battery in time to ensure safe running of the battery.

In existing technologies, discreteness and a change rate of parameters such as an internal resistance are usually used to predict battery thermal runaway. However, this prediction manner is easily affected by conditions such as an external environment and connection, resulting in low accuracy of thermal runaway prediction and easy occurrence of false alarms.

**SUMMARY**

According to a first aspect, the present disclosure provides a method for predicting battery thermal runaway, including the following steps:

obtaining voltage data of a battery to be tested under a preset condition;
obtaining internal resistance data of the battery to be tested according to the preset condition and the voltage data;
processing the internal resistance data based on a preset activation energy model to obtain activation energy data of the battery to be tested; and
determining a thermal runaway probability of the battery to be tested according to the activation energy data.

According to a second aspect, the present disclosure provides a system for predicting battery thermal runaway, including a processing device and a battery pack. The processing device is configured to be connected to a battery to be tested of the battery pack. The processing device includes a processor and a memory coupled to the processor. The memory stores program codes executable by the processor.

The program codes, when executed by the processor, cause the processor to execute the method for predicting battery thermal runaway provided in the present disclosure.

According to a third aspect, the present disclosure provides a non-transitory computer-readable storage medium. The computer-readable storage medium stores a computer program. The computer program, when executed by a processor, causes the processor to execute the methods for predicting battery thermal runaway provided in the present disclosure.

The beneficial effects of the method for predicting battery thermal runaway provided in the present disclosure are: accurate prediction of thermal runaway of the battery to be tested is achieved by obtaining voltage data of the battery to be tested under the preset condition; obtaining internal resistance data of the battery to be tested according to the preset condition and the voltage data; processing the internal resistance data based on a preset activation energy model to obtain activation energy data of the battery to be tested; and determining a thermal runaway probability of the battery to be tested according to the activation energy data. The present disclosure obtains the voltage data of the battery to be tested under the preset condition to calculate the internal resistance data of the battery to be tested, and calculates the activation energy data of the battery to be tested according to the internal resistance data, and then determines, according to the activation energy data, the probability of thermal runaway occurring in the battery to be tested, thereby achieving an advance and accurate prediction of thermal runaway of the battery to be tested, improving the accuracy of the thermal runaway prediction, and thus effectively improving the usage safety of the battery to be tested.

**BRIEF DESCRIPTION OF THE DRAWINGS**

FIG. 1 is a schematic diagram of an application scenario of a method for predicting battery thermal runaway provided in the present disclosure;

FIG. 2 is a first schematic flowchart of a method for predicting battery thermal runaway provided in the present disclosure;

FIG. 3 is a schematic flowchart of a step of obtaining voltage data provided in the present disclosure;

FIG. 4 is a schematic flowchart of a step of obtaining internal resistance data provided in the present disclosure;

FIG. 5 is a second schematic flowchart of a method for predicting battery thermal runaway provided in the present disclosure;

FIG. 6 is a schematic flowchart of a step for determining a thermal runaway probability in a battery pack provided in the present disclosure;

FIG. 7 is a third schematic flowchart of a method for predicting battery thermal runaway provided in the present disclosure;

FIG. 8 is a fourth schematic flowchart of a method for predicting battery thermal runaway provided in the present disclosure;

FIG. 9 is a fifth schematic flowchart of a method for predicting battery thermal runaway provided in the present disclosure;

FIG. 10 is a schematic structural diagram of a system for predicting battery thermal runaway provided in the invention.

## DETAILED DESCRIPTION

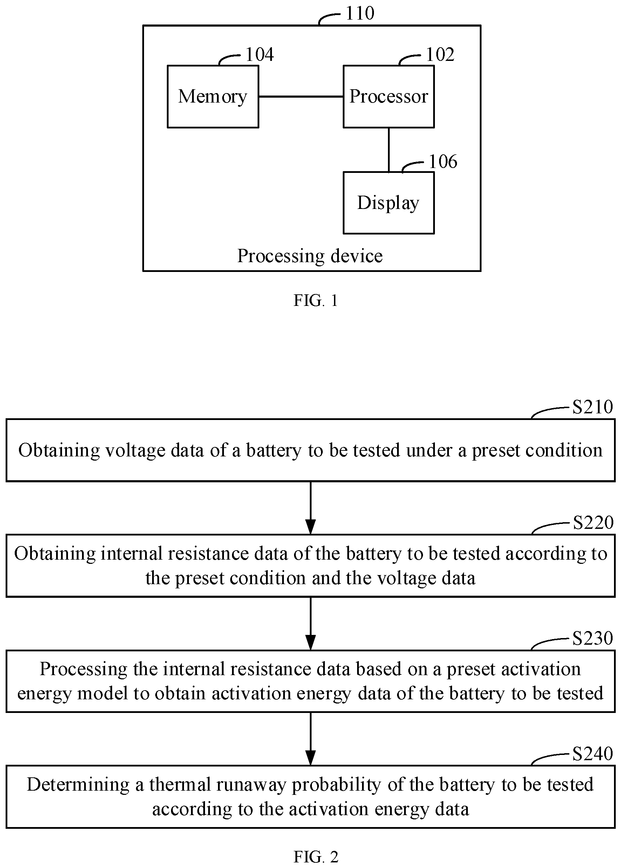

A method for predicting battery thermal runaway provided in the present disclosure may be applied to a processing device 110 as shown in FIG. 1. The processing device 110 may include a processor 102 and a memory 104. The memory 104 may be configured to store data such as voltage data, internal resistance data, activation energy data, thermal runaway probability. The processor 102 may be configured to obtain voltage data of a battery to be tested under a preset condition; obtain internal resistance data of the battery to be tested according to the preset condition and the voltage data; process the internal resistance data based on a preset activation energy model to obtain activation energy data of the battery to be tested; and determine a thermal runaway probability of the battery to be tested according to the activation energy data. The processing device 110 may further include a display 106 that can display, through a graphical interface, data such as voltage data, internal resistance data, activation energy data, and thermal runaway probabilities. Exemplarily, the processing device 110 may be a battery management system (BMS), and the processing device 110 may be provided in a vehicle. The battery to be tested may be a lithium-ion single cell. For example, a plurality of single cells may combined into a battery pack by means of series connection or parallel connection, or by means of two methods at the same time.

In an embodiment, as shown in FIG. 2, a method for predicting battery thermal runaway is provided. The method is described by taking the method applied to the processing device 110 in FIG. 1 as an example, and includes the following steps:

Step S210, obtaining voltage data of a battery to be tested under a preset condition.

The battery to be tested may be applied to a vehicle. The battery to be tested may be a cell with a regular-shaped structure such as a square or a circle. It should be noted that the battery to be tested may also be a cell with an irregular-shaped structure. The battery to be tested may be a lithium-ion cell, for example, the battery to be tested may be a lithium-iron phosphate cell, a ternary cell, a lithium manganese oxide cell, or a lithium manganese iron phosphate cell.

The preset condition refers to a charging/discharging condition of the battery to be tested, for example, the preset condition may be a charging/discharging current, a charging/discharging duration, and a preset temperature of the battery to be tested. It should be noted that the preset temperature may be an ambient temperature or a battery surface temperature of the battery to be tested.

By performing a charging and discharging test on the battery to be tested under the preset condition, and collecting the voltage of the battery to be tested during the test, voltage data of the battery to be tested under the preset condition can be obtained.

Step S220, obtaining internal resistance data of the battery to be tested according to the preset condition and the voltage data.

The internal resistance data may be an internal resistance of an SEI film of the battery to be tested. It should be noted that the SEI film, i.e. the solid electrolyte interface film, is a passivation layer covering a surface of an electrode material and formed when the electrode material reacts with electrolyte at a solid-liquid phase interface during a first charging and discharging of the battery to be tested.

For example, according to the preset condition, a preset temperature and a charging/discharging current are obtained; according to the preset temperature and voltage data, a starting voltage and a termination voltage of the battery to be tested at the preset temperature are determined, and then according to the starting voltage, the termination voltage and the charging/discharging current, the internal resistance data of the corresponding battery to be tested at the preset

EP 4 683 031 A2

temperature is obtained.

Step S230, processing the internal resistance data based on a preset activation energy model to obtain activation energy data of the battery to be tested.

The preset activation energy model can be pre-established according to historical test data.

For example, the internal resistance data of the battery to be tested under different temperatures are input into the preset activation energy model for fitting processing, so as to obtain the activation energy data of the battery to be tested.

Step S240, determining a thermal runaway probability of the battery to be tested according to the activation energy data.

It can be noted that the higher the activation energy of the battery to be tested is, the stronger the stability of the battery to be tested is.

The probability of thermal runaway occurring in the battery to be tested is determined according to the value of the activation energy data, thereby achieving an accurate prediction of the thermal runaway occurring in the battery to be tested.

Exemplarily, a mapping relationship table between activation energy and thermal runaway probability can be established in advance, and according to the processed activation energy data, a thermal runaway probability corresponding to the activation energy data is obtained by querying the mapping relationship table, thereby achieving accurate prediction of thermal runaway of the battery to be tested.

In the above-mentioned embodiment, accurate prediction of thermal runaway of the battery to be tested is achieved by obtaining voltage data of the battery to be tested under the preset condition; obtaining internal resistance data of the battery to be tested according to the preset condition and the voltage data; processing the internal resistance data based on a preset activation energy model to obtain activation energy data of the battery to be tested; and determining a thermal runaway probability of the battery to be tested according to the activation energy data. The present disclosure obtains the voltage data of the battery to be tested under the preset condition to calculate the internal resistance data of the battery to be tested, and calculates the activation energy data of the battery to be tested according to the internal resistance data, and then determines, according to the activation energy data, the probability of thermal runaway occurring in the battery to be tested, thereby achieving an advance and accurate prediction of thermal runaway of the battery to be tested, improving the accuracy of the thermal runaway prediction, and thus effectively improving the usage safety of the battery to be tested.

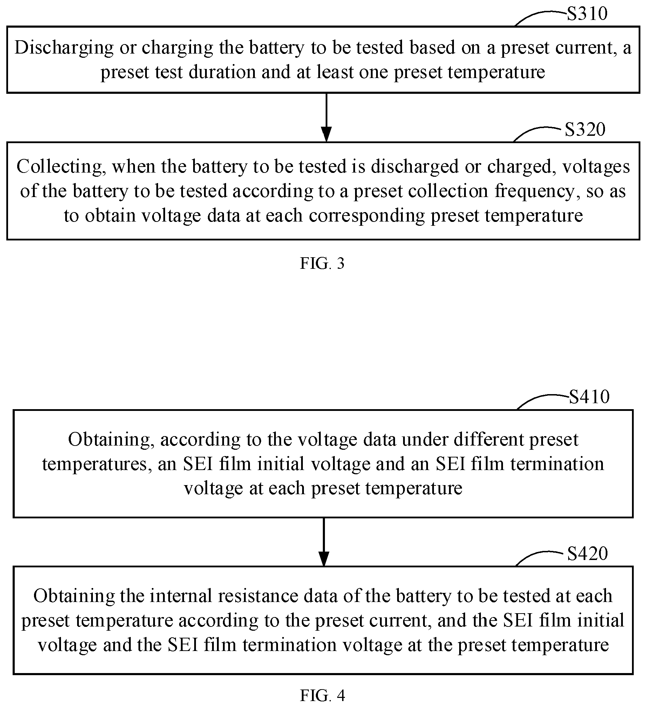

In an embodiment, as shown in FIG. 3, the step of obtaining voltage data of a battery to be tested under a preset condition includes:

Step S310, discharging or charging the battery to be tested based on a preset current, a preset test duration and at least one preset temperature.

The battery to be tested may be charged and discharged using a constant current or a pulse current. For example, when the battery to be tested is charged and discharged using a constant current, the preset current is a constant current. For another example, when the battery to be tested is charged and discharged using a pulse current, the preset current is an average current of the battery to be tested within a charging and discharging period. Exemplarily, the preset current can be set to within $\pm 5\%$ of the average current. It should be noted that, under different temperatures, the preset current (such as the constant current or the average value of the pulse current) for charging and discharging the battery to be tested is the same.

The preset test duration refers to a charging and discharging duration of the battery to be tested. For example, the preset test duration may be 5 seconds, that is, the battery to be tested may be discharged for 5 seconds based on the preset current.

The preset temperature may be an ambient temperature of the battery to be tested. For example, in order to more accurately predict thermal runaway of the battery to be tested, voltage data of the battery to be tested when it is discharged or charged under different temperatures may be collected, for example, voltage data under at least four temperatures is collected. For example, voltage data at preset temperatures of -10°C, 10°C, 25°C and 45°C are collected. It should be noted that a range of the preset temperature may be set to be between -30°C and 55°C, and a gradient of the collected temperature may be set to be greater than 5°C. Exemplarily, the gradient of the collected temperature may be set to be between 10°C and 20°C.

For example, the preset test duration is set to 5 seconds, the preset temperatures are -10°C, 10°C, 25°C, and 45°C, the preset current is a constant current. Then, the battery to be tested is discharged or charged for 5 seconds based on the constant current at the temperatures of -10°C, 10°C, 25°C, and 45°C in sequence, thereby implementing the charge and discharge test of the battery to be tested.

Step S320, collecting, when the battery to be tested is discharged or charged, voltages of the battery to be tested according to a preset collection frequency, so as to obtain voltage data at each preset temperature.

The preset collection frequency is obtained according to a system preset. For example, the preset collection frequency may be set to 100 Hz (i.e. collection is performed every 0.01 second).

For example, the preset collection frequency is set to be 100 Hz, based on a corresponding preset temperature, the battery to be tested is discharged or charged with the preset current for the preset test duration, and the voltage of the battery to be tested is collected to obtain the voltage data of the corresponding preset temperature. According to the voltage data at each corresponding preset temperature, the internal resistance data of each corresponding preset temperature is obtained; the internal resistance data is processed based on the preset activation energy model, so as to obtain the activation energy data of the battery to be tested; according to the activation energy data, the thermal runaway probability of the battery to be tested is determined, and then the thermal runaway of the battery to be tested is accurately predicted, thereby achieving an advance and accurate prediction of thermal runaway of the battery to be tested, improving the accuracy of the thermal runaway prediction, and thus effectively improving the usage safety of the battery to be tested.

In an embodiment, as shown in FIG. 4, the step of obtaining internal resistance data of the battery to be tested according to the preset condition and the voltage data includes:

Step S410, obtaining, according to the voltage data under different preset temperatures, an SEI film initial voltage and an SEI film termination voltage at each preset temperature.

The voltage data may include collected voltages at a plurality of collection moments. The SEI film initial voltage refers to an initial voltage of the SEI film of the battery to be tested, the SEI film termination voltage refers to a termination voltage of the SEI film of the battery to be tested.

For example, based on a corresponding preset temperature, the voltage of the battery to be tested is collected at a preset collection frequency, so as to obtain the collected voltage at each collection moment at the corresponding preset temperature. By processing a plurality of collected voltages at the corresponding preset temperature, the SEI film initial voltage and the SEI film termination voltage at the corresponding preset temperature are obtained.

In an example, the step S410 includes: during a discharge or charge test of the battery to be tested under the same preset temperature, obtaining a first voltage at a previous collection moment and a second voltage at a current collection moment; when a ratio of the first voltage to the second voltage is less than a first threshold, determining the first voltage as the SEI film initial voltage at the corresponding preset temperature; obtaining a third voltage at a moment when an actual test duration reaches the preset test duration; and determining that the third voltage as the SEI film termination voltage at the corresponding preset temperature.

For example, a collection interval is set to 0.01 seconds, the preset test duration is set to t seconds, the first voltage at the previous collection moment is $V(t)$, and the second voltage at the current collection moment is $V(t+0.01)$. The first threshold may be set to any value between 1.2 and 2. The battery to be tested is discharged for t seconds at the same preset temperature and the preset current, and the voltages of the battery to be tested are collected based on the preset collection interval, so as to obtain the voltage at the previous collection moment and the voltage at the current collection moment at the same preset temperature, thereby obtaining the first voltage $V(t)$ and the second voltage $V(t+0.01)$. When $V(t)/V(t+0.01)<Y1$, it is determined that the first voltage $V(t)$ is the SEI film initial voltage at the corresponding preset temperature.

The third voltage refers to a voltage collected at a collection moment corresponding to the preset test duration. For example, if the preset test duration is 0.5 seconds, the third voltage is a voltage collected when the battery to be tested is discharged for 0.5 seconds.

Step S420, obtaining the internal resistance data of the battery to be tested at each preset temperature according to the preset current, and the SEI film initial voltage and the SEI film termination voltage at the preset temperature.

The internal resistance data refers to the internal resistance of the SEI film of the battery to be tested.

The preset current, and the SEI film initial voltage and the SEI film termination voltage at the corresponding preset temperature are processed, so as to obtain the internal resistance data of the battery to be tested at the corresponding preset temperature.

Exemplarily, the preset temperature may be set to -10°C, 10°C, 25°C, and 45°C. By calculating the SEI film initial voltage and the SEI film termination voltage under different temperatures, the internal resistances of the battery to be tested under different temperatures can be obtained. For example, the internal resistance at -10°C is $R(-10°C)$, the internal resistance at 10°C is $R(10°C)$, the internal resistance at 25°C is $R(25°C)$, and the internal resistance at 45°C is $R(45°C)$.

In an example, the step S420 includes: performing differential processing on the SEI film initial voltage and the SEI film termination voltage to obtain a voltage difference value; performing ratio processing on the voltage difference value and the preset current to obtain the internal resistance of the battery to be tested at the corresponding preset temperature.

The SEI film initial voltage is set as $V_{SEI(0)}$, the SEI film termination voltage is set as $V_{SEI(1)}$, and the internal resistance is set as $R_{SEI}$.

Based on an internal resistance formula $R_{SEI}=(V_{SEI(0)}-V_{SEI(1)})/I$, processing the preset current, the SEI film initial voltage and the SEI film termination voltage, so as to obtain the internal resistance R_SEI of the corresponding battery to be tested at the corresponding preset temperature.

In the above embodiment, the internal resistance data of the battery to be tested is calculated based on the SEI film initial voltage and the SEI film termination voltage obtained under the preset condition, which improves the accuracy of internal resistance calculation. Then, the activation energy data of the battery to be tested is calculated based on the internal resistance data, and the probability of thermal runaway of the battery to be tested is determined based on the activation energy data, thereby achieving an advance and accurate prediction of thermal runaway of the battery to be tested, improving the accuracy of the thermal runaway prediction, and thus effectively improving the usage safety of the battery to be tested.

In an embodiment, the step of processing the internal resistance data based on a preset activation energy model to obtain activation energy data of the battery to be tested includes:
inputting a plurality of preset temperatures and internal resistances corresponding to the plurality of preset temperature into the preset activation energy model for fitting processing, so as to obtain the activation energy data of the battery to be tested.

The preset activation energy model can be established by means of historical test data.

By inputting the corresponding preset temperature and the internal resistance corresponding to the corresponding preset temperature into the preset activation energy model for processing, and by means of linear fitting calculation, the activation energy data of the battery to be tested is obtained.

$$\ln\left(\frac{1}{R_{SEI}}\right) = A + \frac{E_a}{B} * \frac{1}{T}$$

In an example, the predetermined activation energy model is .

Where, $E_a$ is the activation energy data; $R_{SEI}$ is an internal resistance at a corresponding preset temperature; A is a first constant; B is a second constant; and T is a preset temperature. For example, the preset activation energy model can be converted into a linear fitting model $E_a = R * k$, where k is a slope. It should be noted that, A is a reaction rate constant, and a value of B can be set as 8.31 J/mol·K.

By inputting the corresponding preset temperature and the internal resistance corresponding to the corresponding preset temperature into the preset activation energy model for processing, and by means of linear fitting calculation, a slope of a linear fitting model can be obtained by means of linear fitting calculation, so that the activation energy data of the battery to be tested can be obtained through calculation.

In the above embodiment, the voltage data of the battery to be tested under the preset condition is obtained to calculate the internal resistance data of the battery to be tested, and fitting processing is performed, based on the preset activation energy model, on each preset temperature and the internal resistance corresponding to each preset temperature to obtain the activation energy data of the battery to be tested, and then the probability of thermal runaway of the battery to be tested is determined according to the activation energy data, thereby achieving an advance and accurate prediction of thermal runaway of the battery to be tested, improving the accuracy of the thermal runaway prediction, and thus effectively improving the usage safety of the battery to be tested.

In an embodiment, the step of discharging or charging the battery to be tested based on a preset current, a preset test duration and at least one preset temperature includes:
when a standing duration of the battery to be tested reaches a preset duration or it is detected that the battery to be tested is in a start-up state, discharging or charging the battery to be tested based on the preset current, the preset test duration and the at least one preset temperature.

The preset duration may be obtained according to a system preset, for example, the preset duration may be set to 30 minutes. The battery to be tested is in the start state, which refers to that the battery to be tested is in a state of just being started.

For example, before collecting voltage of the battery to be tested, the battery is let to stand for 30 minutes, and when a standing duration of the battery to be tested reaches 30 minutes, the battery to be tested is discharged or charged based on the preset current, the preset test duration and the at least one preset temperature, and the voltage of the battery to be tested is collected based on a preset collection frequency, so as to obtain the voltage data of the battery to be tested at the corresponding preset temperature, thereby improving the accuracy of voltage collection, so that in the subsequent calculation steps of the internal resistance and the activation energy, the internal resistance and the activation energy of the battery to be tested can be accurately calculated, and then the probability of thermal runaway occurring in the battery to be tested is determined according to the activation energy data, thereby achieving an advance and accurate prediction of thermal runaway of the battery to be tested, improving the accuracy of the thermal runaway prediction, and thus effectively improving the usage safety of the battery to be tested.

For another example, in order to improve the predictive efficiency of thermal runaway of the battery to be detected, when it is detected that the battery to be tested is in a started state, the battery to be tested is discharged or charged based on the preset current, the preset test duration and at least one preset temperature, and the voltage of the battery to be tested is collected based on a preset collection frequency, so as to obtain voltage data of the battery to be tested at the corresponding preset temperature. Exemplarily, for a new energy vehicle, the voltage of the battery to be tested is collected when the vehicle is just started, so as to obtain the voltage data of the battery to be tested at a corresponding preset temperature.

In an embodiment, the step of discharging or charging the battery to be tested based on a preset current, a preset test duration and at least one preset temperature further includes:

discharging or charging the battery to be tested based on a preset SOC, the preset current, the preset test duration, and the at least one preset temperature.

The preset SOC is preset by the system.

In order to improve the accuracy of voltage collection, by setting the SOC, the battery to be tested is discharged or charged based on the preset SOC, the preset current, the preset test duration and the at least one preset temperature; and the voltage of the battery to be tested is collected based on a preset collection frequency, so as to obtain the voltage data of the battery to be tested at the corresponding preset temperature, thereby improving the accuracy of voltage collection, so that in the subsequent calculation steps of the internal resistance and the activation energy, the internal resistance and the activation energy of the battery to be tested can be accurately calculated, and then the probability of thermal runaway occurring in the battery to be tested is determined according to the activation energy data, thereby achieving an advance and accurate prediction of thermal runaway of the battery to be tested, improving the accuracy of the thermal runaway prediction, and thus effectively improving the usage safety of the battery to be tested.

It should be noted that, the voltages of the battery to be tested is collected based on different preset temperatures, and the SOC (state of charge) of the battery to be tested before being let to stand is within the same value range, for example, the SOC difference is within ±5%.

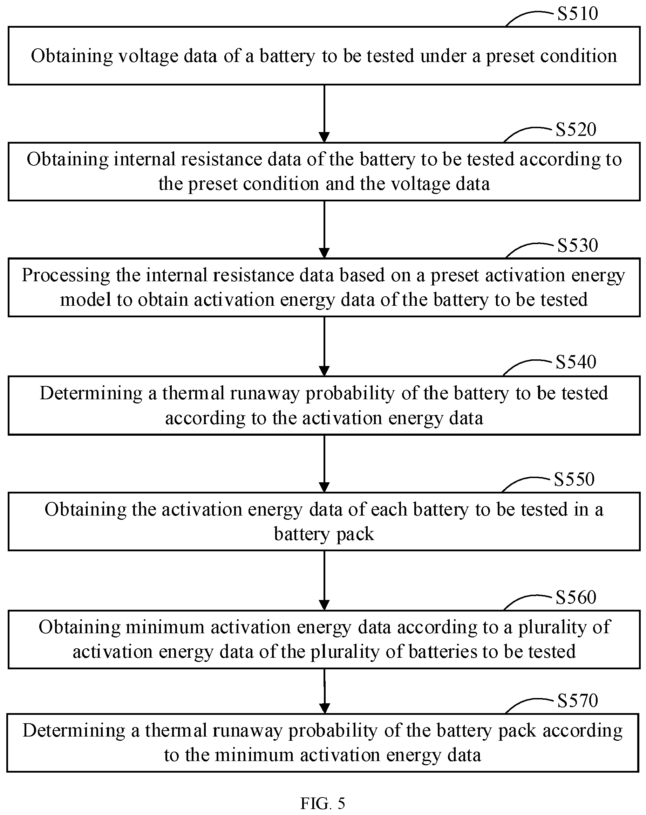

In an embodiment, as shown in FIG. 5, a method for predicting battery thermal runaway is provided. The method is described by taking the method applied to the processing device 110 in FIG. 1 as an example, and includes the following steps:

Step S510, obtaining voltage data of a battery to be tested under a preset condition.

For specific description of the above step S510, reference may be made to the description of the above embodiment, which will not be repeated here.

Step S520, obtaining internal resistance data of the battery to be tested according to the preset condition and the voltage data.

For specific description of the above step S520, reference may be made to the description of the above embodiment, which will not be repeated here.

Step S530, processing the internal resistance data based on a preset activation energy model to obtain activation energy data of the battery to be tested

For specific description of the above step S530, reference may be made to the description of the above embodiment, which will not be repeated here.

Step S540, determining a thermal runaway probability of the battery to be tested according to the activation energy data.

For specific description of the above step S540, reference may be made to the description of the above embodiment, which will not be repeated here.

Step S550, obtaining the activation energy data of each battery to be tested in a battery pack.

The battery pack includes a plurality of the batteries to be tested. The plurality of the batteries to be tested in the battery pack can be connected in series and/or in parallel.

For example, the voltage of each battery to be tested in the same battery pack is collected, so as to obtain voltage data of each battery to be tested. Internal resistance data of the corresponding battery to be tested is calculated, and according to the internal resistance data of the corresponding battery to be tested, activation energy data of the corresponding battery to be tested in the same battery pack is obtained.

step S560, obtaining minimum activation energy data according to a plurality of activation energy data of the plurality of batteries to be tested.

The minimum activation energy data refers to the activation energy with a minimum value among the plurality of activation energy data of the corresponding battery pack.

The activation energy data of the plurality of batteries to be tested in the same battery pack are screened to obtain the minimum activation energy data.

Step S570, determining a thermal runaway probability of the battery pack according to the minimum activation energy data.

It should be noted that the smaller the value of the minimum activation energy data in the same battery pack, the worse the stability of the battery pack.

According to the value of the minimum activation energy data, the probability of thermal runaway occurring in a corresponding battery pack is determined, thereby achieving the accurate prediction of the thermal runaway occurring in the battery pack.

Exemplarily, a mapping relationship table between minimum activation energy and thermal runaway probability can be established in advance, and according to the minimum activation energy data obtained by processing, the thermal runaway probability corresponding to the minimum activation energy data can be obtained by querying the mapping relationship table, thereby achieving accurate prediction of thermal runaway of the battery pack.

In the above embodiment, the voltage data of each battery to be tested in the same battery pack under a preset condition is obtained to calculate the internal resistance data of each battery to be tested, and the activation energy data of each battery to be tested in the same battery pack is calculated according to the internal resistance data of each battery to be tested, then the minimum activation energy data of the corresponding battery pack is determined according to a plurality of activation energy data, and then the probability of thermal runaway occurring in a corresponding battery pack is determined according to the minimum activation energy data, thereby achieving an advance and accurate prediction of thermal runaway of the battery pack, improving the accuracy of thermal runaway prediction, and thus effectively improving the usage safety of the battery pack.

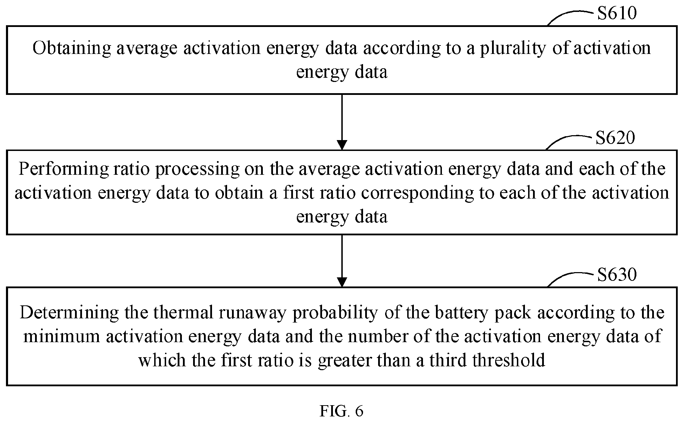

In an embodiment, as shown in FIG. 6, the step of determining a thermal runaway probability of the battery pack according to the minimum activation energy data includes:

Step S610, obtaining average activation energy data according to the plurality of activation energy data.

The average activation energy data refers to an average value of the activation energy data of the plurality of batteries to be tested of the corresponding battery pack.

For example, the battery pack includes n batteries to be tested. By calculating the activation energy of each battery to be tested in the same battery pack, a plurality of the activation energy data are respectively obtained as $E_a(1)$ to $E_a(n)$. By averaging $E_a(1)$ to $E_a(n)$, the average activation energy data $E_a(mean)$ is then obtained.

Step S620, performing ratio processing on the average activation energy data and each of the activation energy data to obtain a first ratio corresponding to each of the activation energy data.

The first ratio may be obtained by dividing the average activation energy data by the activation energy data of the corresponding battery to be tested.

By performing ratio processing on the average activation energy $E_a(mean)$ and the activation energy data of each battery to be tested in the same battery pack, the first ratio of each corresponding battery to be tested is obtained.

Step S630, determining the thermal runaway probability of the battery pack according to the minimum activation energy data and the number of the activation energy data of which the first ratio is greater than a third threshold.

The third threshold may be preset by a system. For example, the third threshold may be set to any value between 1.05 and 1.5. When the first ratio of the corresponding battery to be tested is greater than the third threshold, the probability of thermal runaway occurring in the battery to be tested is high. For example, the third threshold is set to Y2, when the first ratio of the average activation energy $E_a(mean)$ to the activation energy data of a certain battery i to be detected. I.e., $E_a(mean)/E_a(i)>Y2$, the probability of thermal runaway occurring in the battery i to be detected is relatively high.

According to the value of the minimum activation energy data and the number of the activation energy data of which the first ratio is greater than the third threshold, the probability of thermal runaway occurring in a corresponding battery pack is determined, thereby realizing the accurate prediction of the thermal runaway occurring in the battery pack.

In the above embodiment, the voltage data of each battery to be tested in the same battery pack under a preset condition is obtained to calculate the internal resistance data of each battery to be tested, and the activation energy data of each battery to be tested in the same battery pack is calculated according to the internal resistance data of each battery to be tested, and then the minimum activation energy data and the average activation energy data of the corresponding battery pack are determining according to a plurality of activation energy data; and according to the minimum activation energy data and the number of the first ratio being greater than the third threshold, the probability of thermal runaway occurring in a corresponding battery pack is determined, thereby achieving an advance and accurate prediction of thermal runaway of the battery pack, improving the accuracy of thermal runaway prediction of the battery pack, and thus effectively improving the usage safety of the battery pack.

In an example, after the step of performing ratio processing on the average activation energy data and each of the activation energy data to obtain a first ratio corresponding to each of the activation energy data, the method includes: when any one of the first ratios is greater than the third threshold, outputting a thermal runaway pre-warning of the battery to be tested of which the first ratio is greater than the third threshold.

The thermal runaway pre-warning may be referred to as a sound pre-warning, an information pre-warning or a light pre-warning. For example, when the thermal runaway pre-warning of the battery to be tested is triggered, the sound pre-warning, the information pre-warning or the light pre-warning may be output to remind the user to maintain or replace the corresponding battery to be tested in time.

By calculating the ratio of the average activation energy data in the same battery pack to the activation energy data of each battery to be tested, a plurality of first ratios in the same battery pack are obtained. By comparing a plurality of first ratios in the same battery pack with the third threshold, and when any one of the first ratio is greater than the third threshold, it is determined that the probability of thermal runaway occurring in the corresponding battery to be tested is relatively high, and then a thermal runaway pre-warning of the battery to be tested of which the first ratio is greater than the third threshold is output to remind the user in time.

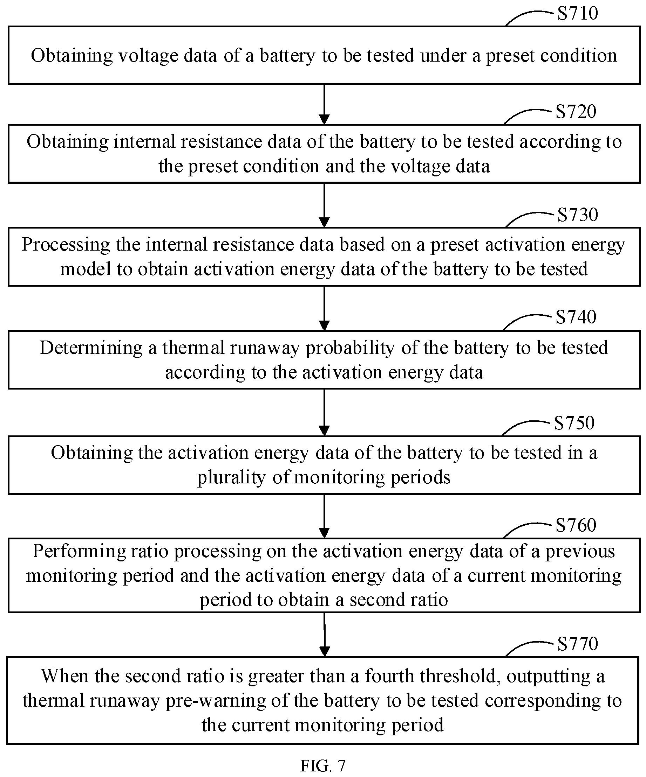

In an embodiment, as shown in FIG. 7, a method for predicting battery thermal runaway is provided. The method is described by taking the method applied to the processing device 110 in FIG. 1 as an example, and includes the following steps:

Step S710, obtaining voltage data of a battery to be tested under a preset condition.

For specific description of the above step S710, reference may be made to the description of the above embodiment, which will not be repeated here.

Step S720, obtaining internal resistance data of the battery to be tested according to the preset condition and the voltage data.

For specific description of the above step S720, reference may be made to the description of the above embodiment, which will not be repeated here.

Step S730, processing the internal resistance data based on a preset activation energy model to obtain activation energy data of the battery to be tested

For specific description of the above step S730, reference may be made to the description of the above embodiment, which will not be repeated here.

Step S740, determining a thermal runaway probability of the battery to be tested according to the activation energy data.

For specific description of the above step S740, reference may be made to the description of the above embodiment, which will not be repeated here.

Step S750, obtaining the activation energy data of the battery to be tested in a plurality of monitoring periods.

The monitoring period refers to a time point at which the ageing process of the battery to be tested is monitored. For example, the activation energy monitoring is performed once for each period of time of use of the battery to be tested, so as to obtain activation energy data of the battery to be tested in at least one monitoring period.

Step S760, performing ratio processing on the activation energy data of a previous monitoring period and the activation energy data of a current monitoring period to obtain a second ratio.

The second ratio is obtained by dividing the activation energy data of the previous monitoring period by the activation energy data of the current monitoring period.

By performing ratio processing on the activation energy data of the previous monitoring period and the activation energy data of the current monitoring period, the second ratio of the corresponding battery to be tested is obtained.

For example, considering that during use of the battery to be tested, due to continuous aging, the activation energy of the battery to be tested may decrease as the battery ages, so thermal runaway may occur. By comparing the activation energy of the battery to be tested in different monitoring periods, a probability that thermal runaway occurs in the battery to be tested in the current monitoring period can be determined. For example, the activation energy data of the battery to be tested when it is just offline is $E_a(0M)$, and the activation energy data after a period of use is $E_a(1)$, $E_a(2)$, $E_a(3)$, etc. Setting the activation energy data for the previous monitoring period to $E_a(T_{i-1})$, the activation energy data for the current monitoring period to $E_a(T_i)$, and the second ratio to F, then $F=E_a(T_{i-1})/E_a(T_i)$.

Step S770, when the second ratio is greater than a fourth threshold, outputting a thermal runaway pre-warning of the battery to be tested corresponding to the current monitoring period.

The fourth threshold may be set to any value between 1.1 and 1.8. The thermal runaway pre-warning may be a sound pre-warning, an information pre-warning or a light pre-warning. For example, when the thermal runaway pre-warning of the battery to be tested is triggered, the sound pre-warning, the information pre-warning or the light pre-warning may be output to remind the user to maintain or replace the corresponding battery to be tested in time.

The fourth threshold is set as Y3, the activation energy data of the previous monitoring period is $E_a(T_{i-1})$, and the activation energy data of the current monitoring period is $E_a(T_i)$, then $E_a(T_{i-1})/E_a(T_i)>Y3$, it is determined that the probability that thermal runaway occurs in the corresponding battery to be tested in the current monitoring period is relatively high.

By calculating the ratio of the activation energy data of the battery to be tested in the previous monitoring period to the activation energy data of the battery to be tested in the current monitoring period, the second ratio of the activation energy data of the battery to be tested in adjacent monitoring periods is obtained. By comparing the second ratio of the battery to be tested with the fourth threshold, and when the second ratio is greater than the fourth threshold, it is determined that the probability of thermal runaway of the corresponding battery to be tested occurring in the current monitoring period is relatively high, and then a thermal runaway pre-warning of the battery to be tested of which the second ratio is greater than the third threshold is output to remind the user in time.

In the above embodiment, the voltage data of the battery to be tested under a preset condition is obtained to calculate the internal resistance data of the battery to be tested, and according to the internal resistance data of the battery to be tested, the activation energy data of the corresponding battery to be tested in different monitoring periods are calculated, furthermore, according to the activation energy data in each monitoring period, the ratio of the activation energy data in the previous monitoring period to the activation energy data in the current monitoring period is determined, and when the second ratio is greater than the fourth threshold, it is determined that the probability of thermal runaway of the battery to be tested occurring in the current monitoring period is relatively high, and a thermal runaway pre-warning is output, thereby achieving an advance and accurate prediction of battery thermal runaway to be tested, reminding the user in time, and improving accuracy of prediction of thermal runaway of the battery to be tested, and thus effectively improving the usage safety of the battery to be tested.

It should be understood that, although the steps in the flowcharts of FIG. 2 to FIG. 7 are displayed sequentially as indicated by arrows, these steps are not necessarily executed sequentially in the order indicated by the arrows. Unless otherwise specified herein, there is no strict order limitation for the execution of these steps, and these steps may be executed in other orders. Moreover, at least some of the steps of FIG. 2 to FIG. 7 may include multiple sub-steps or multiple stages. These sub-steps or stages are not necessarily executed at the same time, but may be executed at different times. The execution order of these sub-steps or stages is also not necessarily sequential, but may be executed in turn or alternatively with other steps, or the sub-steps of other steps, or at least a part of stages.

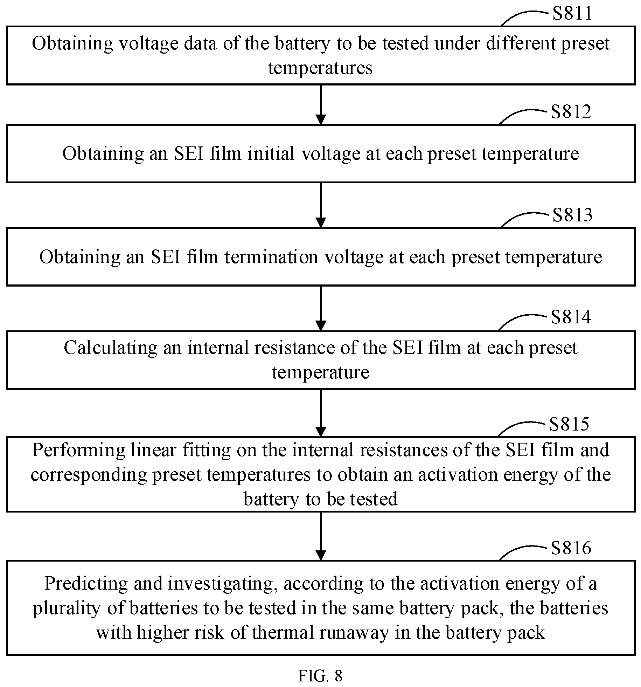

In an embodiment, as shown in FIG. 8, a method for predicting battery thermal runaway is provided. In this embodiment, the method is described by taking an example in which a battery to be tested is a power battery in a battery pack used in a new energy vehicle. The method includes the following steps:

Step S811, obtaining voltage data of the battery to be tested under different preset temperatures.

Specifically, in a process of starting and running the vehicle, the voltage data of each battery to be tested in the battery pack may be collected, and an interval of the voltage collection may be set to be 0.01 seconds.

When the vehicle starts up under different temperatures, the voltages of the battery to be tested are collected under the following discharge conditions: the temperatures are -15°C, 3°C, 18°C and 35°C, an SOC of the battery to be tested is 80%, and the battery to be tested is discharged for 10 seconds with an average current I of about 88A.

Step 812, obtaining an SEI film initial voltage at each preset temperature.

Specifically, a first threshold Y1 can be set to be 1.3, and SEI film initial voltages under different preset temperatures can be obtained by comparing V(t)/V(t+0.01) with the first threshold Y1, for example, $V_{SEI(0)}$ at a temperature of -15°C is 3.195V; $V_{SEI(0)}$ at a temperature of 3°C is 3.226V; $V_{SEI(0)}$ at a temperature of 18°C is 3.246V; $V_{SEI(0)}$ at a temperature of 35°C is 3.267V.

Step S813, obtaining an SEI film termination voltage $V_{SEI(1)}$ at each preset temperature.

Specifically, the SEI film termination voltages $V_{SEI(1)}$ under different temperatures may be obtained. For example, $V_{SEI(1)}$ at a temperature of -15°C is 3.107V; $V_{SEI(1)}$ at a temperature of 3°C is 3.169V; $V_{SEI(1)}$ at a temperature of 18°C is 3.205V; $V_{SEI(1)}$ at a temperature of 35°C is 3.244V.

Step S814, calculating an internal resistance of the SEI film at each preset temperature.

According to the above description, the internal resistance of the SEI film is the internal resistance of the battery to be tested. The internal resistances of the SEI film under different preset temperatures are calculated based on a formula $R_{SEI}=(V_{SEI(0)}-V_{SEI(1)})/I$, where $R_{SEI}$ is the internal resistance of the SEI film of the battery to be tested. For example, it is calculated that $R_{SEI}$ at a temperature of -15°C is 1mΩ; $R_{SEI}$ at a temperature of 3°C is 0.478mΩ; $R_{SEI}$ at a temperature of 18°C is 0.466mΩ; and $R_{SEI}$ at a temperature of 35°C is 0.261mΩ.

Step S815, performing linear fitting on the internal resistances of the SEI film and corresponding preset temperatures to obtain an activation energy of the battery to be tested.

Specifically, linear fitting may be performed through a preset activation energy model

$$\ln\left(\frac{1}{R_{SEI}}\right) = A + \frac{E_a}{B} * \frac{1}{T}$$

between a preset temperature and an internal resistance, so as to obtain that the activation energy of the battery to be tested is 17.66 kJ/mol.

By repeating the above steps S811 to S815, the activation energy data of all the batteries to be tested in the battery pack can be obtained as shown in the following table:

| Cell | 1 | 2 | 3 | 4 | 5 | 6 | 7 | 8 | 9 | 10 |
|------|------|------|------|------|------|------|------|------|------|------|
| Activation energy $E_a$ (kJ/mol) | 17.66 | 17.58 | 17.48 | 17.48 | 17.86 | 17.61 | 17.43 | 17.48 | 17.46 | 17.79 |
| Cell | 11 | 12 | 13 | 14 | 15 | 16 | 17 | 18 | 19 | 20 |
| Activation energy $E_a$ (kJ/mol) | 17.63 | 17.89 | 17.46 | 17.69 | 17.79 | 17.86 | 17.43 | 17.86 | 17.46 | 17.66 |
| Cell | 21 | 22 | 23 | 24 | 25 | 26 | 27 | 28 | 29 | 30 |
| Activation energy $E_a$ (kJ/mol) | 17.66 | 17.76 | 17.53 | 17.86 | 17.79 | 17.51 | 17.69 | 17.81 | 17.24 | 17.66 |
| Cell | 31 | 32 | 33 | 34 | 35 | 36 | 37 | 38 | 39 | 40 |
| Activation energy $E_a$ (kJ/mol) | 17.66 | 17.46 | 17.79 | 17.48 | 17.58 | 17.86 | 17.56 | 17.86 | 17.89 | 17.51 |
| Cell | 41 | 42 | 43 | 44 | 45 | 46 | 47 | 48 | 49 | 50 |
| Activation energy $E_a$ (kJ/mol) | 17.89 | 17.81 | 17.48 | 17.71 | 17.56 | 17.66 | 17.58 | 17.51 | 17.58 | 17.61 |
| Cell | 51 | 52 | 53 | 54 | 55 | 56 | 57 | 58 | 59 | 60 |
| Activation energy $E_a$ (kJ/mol) | 17.74 | 17.61 | 17.81 | 17.16 | 17.89 | 15.78 | 17.58 | 17.71 | 17.61 | 17.61 |

(continued)

| Cell | 61 | 62 | 63 | 64 | 65 | 66 | 67 | 68 | 69 | 70 |
|---|---|---|---|---|---|---|---|---|---|---|
| Activation energy $E_a$ (kJ/mol) | 17.51 | 17.79 | 17.71 | 17.43 | 17.84 | 17.86 | 17.84 | 17.79 | 17.71 | 17.66 |
| Cell | 71 | 72 | 73 | 74 | 75 | 76 | 77 | 78 | 79 | 80 |
| Activation energy $E_a$ (kJ/mol) | 17.58 | 17.69 | 17.56 | 17.46 | 17.76 | 17.84 | 17.86 | 17.79 | 17.74 | 17.69 |
| Cell | 81 | 82 | 83 | 84 | 85 | 86 | 87 | 88 | 89 | 90 |
| Activation energy $E_a$ (kJ/mol) | 17.69 | 17.51 | 17.81 | 17.71 | 17.63 | 17.58 | 17.53 | 17.48 | 17.69 | 17.46 |
| Cell | 91 | 92 | 93 | 94 | 95 | 96 | | | | |
| Activation energy $E_a$ (kJ/mol) | 17.46 | 17.71 | 17.74 | 17.76 | 17.58 | 17.76 | | | | |

Step S816, predicting and investigating, according to the activation energy of a plurality of batteries to be tested in the same battery pack, the batteries with higher risk of thermal runaway in the battery pack.

Specifically, by comparing the activation energy of a cell with the average activation energy of the plurality of batteries to be tested in the battery pack, and setting a third threshold Y2 to 1.1, it can be found that the activation energy of the battery to be tested of No. 56 as recorded in the above table is relatively low and exceeds the third threshold. It can be determined that the probability of thermal runaway occurring in the battery to be tested of No. 56 is relatively high, and it is possible to predict whether the probability of thermal runaway occurring in a certain battery to be tested in the battery pack is high, thereby improving the accuracy and robustness of prediction of thermal runaway of the battery to be tested.

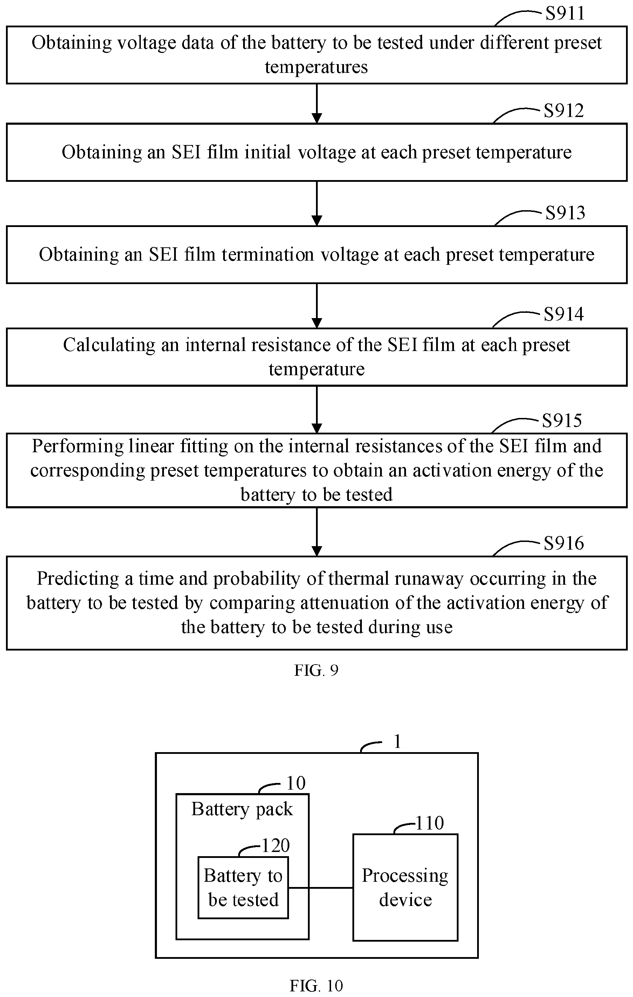

In an embodiment, as shown in FIG. 9, a method for predicting battery thermal runaway is provided. In this embodiment, the method is described by taking an example in which a battery to be tested is a power battery in a battery pack used in a new energy vehicle. By means of the method, a risk of thermal runaway occurring after the the battery is aged during the use of the battery to be tested can be tracked and detected. The method includes the following steps: Step S911, obtaining voltage data of the battery to be tested under different preset temperatures.

Specifically, for the battery to be tested, voltage data of the battery to be tested which is pulsed discharged under different preset temperatures in its initial state can be collected, and an interval of the voltage collection may be set to be 0.01 seconds.

During a running process of the vehicle, the voltage data of the battery to be tested is collected under the following discharge conditions: the temperatures are -7°C, 10°C, 24°C and 38°C, an SOC is about 75%, and the battery to be tested is pulse discharged for 7s with an average current of 106A.

Step 912, obtaining an SEI film initial voltage at each preset temperature.

Specifically, a first threshold Y1 can be set to be 1.36, and SEI film initial voltages under different preset temperatures can be obtained by comparing V(t)/V(t+0.01) with the first threshold Y1, for example, $V_{SEI(0)}$ at a temperature of -7°C is 3.665V; $V_{SEI(0)}$ at a temperature of 10°C is 3.724V; $V_{SEI(0)}$ at a temperature of 24°C is 3.764V; $V_{SEI(0)}$ at a temperature of 38°C is 3.790V.

Step 913, obtaining an SEI film termination voltage $V_{SEI(1)}$ at each preset temperature.

Specifically, the SEI film termination voltages $V_{SEI(1)}$ under different temperatures may be obtained. For example, $V_{SEI(1)}$ at a temperature of -7°C is 3.516V; $V_{SEI(1)}$ at a temperature of 10°C is 3.631V; $V_{SEI(1)}$ at a temperature of 24°C is 3.710V; $V_{SEI(1)}$ at a temperature of 38°C is 3.753V.

Step 914, calculating an internal resistance of the SEI film at each preset temperature.

According to the above description, the internal resistance of the SEI film is the internal resistance of the battery to be tested. The internal resistances of the SEI film under different preset temperatures are calculated based on a formula $R_{SEI}=(V_{SEI(0)}-V_{SEI(1)})/I$, where $R_{SEI}$ is the internal resistance of the SEI film of the battery to be tested. For example, it is calculated that $R_{SEI}$ at a temperature of -7°C is 1.405mΩ; $R_{SEI}$ at a temperature of 10°C is 0.877mΩ; $R_{SEI}$ at a temperature of 24°C is 0.509mΩ; and $R_{SEI}$ at a temperature of 38°C is 0.349mΩ.

Step 915, performing linear fitting on the internal resistances of the SEI film and corresponding preset temperatures to obtain an activation energy of the battery to be tested.

Specifically, linear fitting may be performed through a preset activation energy model

$$\ln\left(\frac{1}{R_{SEI}}\right) = A + \frac{E_a}{B} * \frac{1}{T}$$

between a preset temperature and an internal resistance, so as to obtain that the activation energy of the battery to be tested in an initial state is 22.35 kJ/mol.

During long-term use of the battery to be tested, for example, from the 1st to 8th years, by repeating the above steps S911 to S915, long-term monitoring can be performed on the battery to be tested. The activation energy of the battery from the 1st to 8th years can be obtained as shown in the following table:

| Usage time (year) | 1 | 2 | 3 | 4 | 5 | 6 | 7 | 8 |
|---|---|---|---|---|---|---|---|---|
| Activation energy (kJ/mol) | 22.35 | 22.03 | 21.48 | 21.19 | 20.78 | 20.15 | 19.64 | 15.13 |

Step S916, predicting a time and probability of thermal runaway occurring in the battery to be tested by comparing attenuation of the activation energy of the battery to be tested during use.

Specifically, by comparing the activation energy decline trend, and setting a fourth threshold Y3 set to be 1.2, when $E_a(T_i)/E_a(T_{i+1}) > 1.2$, the battery to be tested is at risk of thermal runaway occurring. It can be found that a magnitude of the decrease in the activation energy of the battery to be tested in the 8th year exceeds the fourth threshold, and the probability of thermal runaway is relatively high. This enables prediction of the risk of thermal runaway occurring in the battery to be tested after the performance of the battery to be tested is degraded a during long-term use.

In an embodiment, the present disclosure provides an apparatus for predicting battery thermal runaway, which includes a voltage obtaining unit, an internal resistance calculation unit, an activation energy calculation unit, and a thermal runaway prediction unit.

The voltage obtaining unit is configured to obtain voltage data of a battery to be tested under a preset condition.

The internal resistance calculation unit is configured to obtaining internal resistance data of the battery to be tested according to the preset condition and the voltage data.

The activation energy calculation unit is configured to process the internal resistance data based on a preset activation energy model, so as to obtain activation energy data of the battery to be tested.

The thermal runaway prediction unit is configured to determine a thermal runaway probability of the battery to be tested according to the activation energy data.

For limitations to the apparatus for predicting battery thermal runaway, reference may be made to the foregoing limitations to the method for predicting battery thermal runaway, and details are not described herein again. Each module in the above apparatus for predicting battery thermal runaway may be fully or partially implemented by software, hardware, or a combination thereof. Each of the above modules may be embedded in or independent of the above processing device 110 in a form of hardware, and may also be stored in the above memory 104 of the processing device 110 in a form of software, so that the processor 102 can call and execute an operation corresponding to each of the above modules.

In an embodiment, as shown in FIG. 10, a system 1 for predicting battery thermal runaway is further provided, which includes a processing device 110 and a battery pack 10. The battery pack 10 includes at least one battery 120 to be tested. The processing device 110 is configured to be configured to be connected to the battery 120 to be tested.

The processing device 110 may include a BMS. The battery 120 to be tested may be a lithium-ion cell.

As shown in FIG. 1, the processing device 110 may include a processor 102 and a memory 104 coupled to the processor 102. The memory 104 is further configured to store program codes executable by the processor 102. The program codes, when executed by the processor 102, cause the processor 102 to execute the method for predicting battery thermal runaway described in any one of the above embodiments.

Specifically, the processor 102 is caused to: obtain voltage data of the battery 120 to be tested under a preset condition; obtain internal resistance data of the battery 120 to be tested according to the preset condition and the voltage data; process the internal resistance data based on a preset activation energy model to obtain activation energy data of the battery 120 to be tested; and determine a thermal runaway probability of the battery 120 to be tested according to the activation energy data, thereby realizing accurate prediction of thermal runaway of the battery 120 to be tested.

In the foregoing embodiment, the processing device 110 obtains the voltage data of the battery 120 to be tested under the preset condition to calculate the internal resistance data of the battery 120 to be tested, and calculates the activation energy data of the battery 120 to be tested according to the internal resistance data, and then determines, according to the activation energy data, the probability of thermal runaway occurring in the battery 120 to be tested, thereby achieving an advance and accurate prediction of thermal runaway of the battery 120 to be tested, improving the accuracy of the thermal runaway prediction, and thus effectively improving the usage safety of the battery 120 to be tested.

In an embodiment, a non-transitory computer-readable storage medium is further provided. The computer-readable storage medium stores a computer program. The computer program, when executed by a processor, causes the processor to execute the method for predicting battery thermal runaway according to any one of the foregoing embodiments.

For example, when the computer program is executed by the processor, the steps of the method for the prediction of battery thermal runaway are implemented as follows:

obtaining voltage data of a battery to be tested under a preset condition; obtaining internal resistance data of the battery to be tested according to the preset condition and the voltage data; processing the internal resistance data based on a preset activation energy model to obtain activation energy data of the battery to be tested; and determining a thermal runaway probability of the battery to be tested according to the activation energy data, thereby realizing accurate prediction of thermal runaway of the battery to be tested.

Persons of ordinary skill in the art should understand that all or a part of the process in the method according to the above embodiments may be implemented by a computer program instructing relevant hardwares. The computer program provided in the present disclosure may be stored in a non-transitory computer-readable storage medium, and when executed, the computer program may include the steps of a plurality of division operation methods according to the embodiments as described above. Any references to memory, storage, database, or other media used in the embodiments provided herein may include non-volatile and/or volatile memory. The non-volatile memory may include read only memory (ROM), programmable ROM (PROM), electrically programmable ROM (EPROM), electrically erasable programmable ROM (EEPROM), or flash memory. The volatile memory may include a random access memory (RAM) or an external cache memory. By way of illustration and not limitation, RAM is available in a variety of forms, such as static RAM (SRAM), dynamic RAM (DRAM), synchronous DRAM (SDRAM), double data rate SDRAM (DDR SDRAM), enhanced SDRAM (ESDRAM), Synchlink DRAM (SLDRAM), Rambus DRAM (RDRAM), direct memory bus DRAM (DRRAM), and memory bus dynamic RAM (RDRAM), etc.

## Claims

1. A method for predicting battery thermal runaway, comprising:

    obtaining voltage data of a battery to be tested under a preset condition;
    obtaining internal resistance data of the battery to be tested according to the preset condition and the voltage data;
    processing the internal resistance data based on a preset activation energy model to obtain activation energy data of the battery to be tested; and
    determining a thermal runaway probability of the battery to be tested according to the activation energy data.

2. The method for predicting battery thermal runaway according to claim 1, wherein the obtaining voltage data of a battery to be tested under a preset condition comprises:

    discharging or charging the battery to be tested based on a preset current, a preset test duration and at least one preset temperature;
    collecting, when the battery to be tested is discharging or charging, voltages of the battery to be tested according to a preset collection frequency, so as to obtain voltage data at each preset temperature.

3. The method for predicting battery thermal runaway according to claim 2, wherein the obtaining internal resistance data of the battery to be tested according to the preset condition and the voltage data comprises:

    obtaining, according to the voltage data under different preset temperatures, an SEI film initial voltage and an SEI film termination voltage at each preset temperature;
    obtaining the internal resistance data of the battery to be tested at each preset temperature according to the preset current, and the SEI film initial voltage and the SEI film termination voltage at the preset temperature.

4. The method for predicting battery thermal runaway according to claim 3, wherein the obtaining, according to the voltage data under different preset temperatures, an SEI film initial voltage and an SEI film termination voltage at each preset temperature comprises:

    obtaining, during a discharge or charge test of the battery to be tested under the same preset temperature, a first voltage at a previous collection moment and a second voltage at a current collection moment under;
    when a ratio of the first voltage to the second voltage is less than a first threshold, determining the first voltage as the SEI film initial voltage at the corresponding preset temperature;
    obtaining a third voltage at a moment when an actual test duration reaches the preset test duration; and
    determining the third voltage as the SEI film termination voltage at the corresponding preset temperature.

5. The method for predicting battery thermal runaway according to claim 3, wherein the step of obtaining the internal resistance data of the battery to be tested at each preset temperature according to the preset current, and the SEI film initial voltage and the SEI film termination voltage at the preset temperature comprises:

    performing differential processing on the SEI film initial voltage and the SEI film termination voltage to obtain a voltage difference value;
    performing ratio processing on the voltage difference value and the preset current to obtain the internal resistance of the battery to be tested at the corresponding preset temperature.

6. The method for predicting battery thermal runaway according to claim 5, wherein the processing the internal resistance data based on a preset activation energy model to obtain activation energy data of the battery to be tested comprises:
inputting a plurality of preset temperatures and internal resistances corresponding to the plurality of preset temperature into the preset activation energy model for fitting processing, so as to obtain the activation energy data of the battery to be tested

7. The method for predicting battery thermal runaway according to claim 6, wherein the preset activation energy model is:

$$\ln\left(\frac{1}{R_{SEI}}\right) = A + \frac{E_a}{B} * \frac{1}{T},$$

wherein, $E_a$ is the activation energy data; $R_{SEI}$ is an internal resistance at a corresponding preset temperature; A is a first constant; B is a second constant; and T is a preset temperature.

8. The method for predicting battery thermal runaway according to claim 2, wherein the discharging or charging the battery to be tested based on a preset current, a preset test duration and at least one preset temperature comprises:
when a standing duration of the battery to be tested reaches a preset duration or it is detected that the battery to be tested is in a start-up state, discharging or charging the battery to be tested based on the preset current, the preset test duration and the at least one preset temperature.

9. The method for predicting battery thermal runaway according to claim 2, wherein the discharging or charging the battery to be tested based on a preset current, a preset test duration and at least one preset temperature further comprises:
discharging or charging the battery to be tested based on a preset SOC, the preset current, the preset test duration, and the at least one preset temperature.

10. The method for predicting battery thermal runaway according to any one of claims 1 to 9, wherein the battery to be tested is provided in a battery pack, wherein the battery pack comprises a plurality of the batteries to be tested;
wherein after the determining a thermal runaway probability of the battery to be tested according to the activation energy data, the method further comprises:

obtaining the activation energy data of each battery to be tested in the battery pack;
obtaining minimum activation energy data according to a plurality of activation energy data of the plurality of the batteries to be tested;
determining a thermal runaway probability of the battery pack according to the minimum activation energy data.

11. The method for predicting battery thermal runaway according to claim 10, wherein the determining a thermal runaway probability of the battery pack according to the minimum activation energy data comprises:

obtaining average activation energy data according to the plurality of activation energy data;
performing ratio processing on the average activation energy data and each of the activation energy data to obtain a first ratio corresponding to each of the activation energy data;
determining the thermal runaway probability of the battery pack according to the minimum activation energy data and the number of the activation energy data of which the first ratio is greater than a third threshold.

12. The method for predicting battery thermal runaway according to claim 11, wherein after the performing ratio processing on the average activation energy data and each of the activation energy data to obtain a first ratio corresponding to each of the activation energy data, the method comprises:
when any one of the first ratios is greater than the third threshold, outputting a thermal runaway pre-warning of the battery to be tested of which the first ratio is greater than the third threshold.

13. The method for predicting battery thermal runaway according to any one of claims 1 to 9, wherein after the determining a thermal runaway probability of the battery to be tested according to the activation energy data, the method further comprises:

obtaining the activation energy data of the battery to be tested in a plurality of monitoring periods;
performing ratio processing on the activation energy data of a previous monitoring period and the current activation energy data of a current monitoring period to obtain a second ratio; and
when the second ratio is greater than a fourth threshold, outputting a thermal runaway pre-warning of the battery to be tested corresponding to the current monitoring period.

14. A system (1) for predicting battery thermal runaway, comprising a processing device (110) and a battery pack (10), wherein the processing device (110) is configured to be connected to a battery (120) to be tested of the battery pack (10); the processing device (110) comprises:

a processor (102); and
a memory (104) coupled to the processor (102) and storing program codes executable by the processor (102); wherein the program codes, when executed by the processor (102), cause the processor (102) to executethe method for predicting battery thermal runaway according to any one of claims 1 to 13.

15. A non-transitory computer-readable storage medium, wherein the computer-readable storage medium stores a computer program; wherein the computer program, when executed by a processor, causes the processor to execute the method for predicting battery thermal runaway according to any one of claims 1 to 13.

110

┌─────────────────────────────────────────┐
│                                          │
│   ┌──104           ┌──102                │
│   ┌──────────┐     ┌──────────┐          │
│   │  Memory  │─────│ Processor│          │
│   └──────────┘     └──────────┘          │
│                          │               │
│                       ┌──106             │
│                    ┌──────────┐          │
│                    │ Display  │          │
│                    └──────────┘          │
│                                          │
│            Processing device             │
└─────────────────────────────────────────┘

FIG. 1

┌───────────────────────────────────────────────────────┐ ┌─S210
│ Obtaining voltage data of a battery to be tested under a preset condition │
└───────────────────────────────────────────────────────┘
                            │
                            ▼
┌───────────────────────────────────────────────────────┐ ┌─S220
│ Obtaining internal resistance data of the battery to be tested according to │
│           the preset condition and the voltage data        │
└───────────────────────────────────────────────────────┘
                            │
                            ▼
┌───────────────────────────────────────────────────────┐ ┌─S230
│  Processing the internal resistance data based on a preset activation       │
│ energy model to obtain activation energy data of the battery to be tested   │
└───────────────────────────────────────────────────────┘
                            │
                            ▼
┌───────────────────────────────────────────────────────┐ ┌─S240
│ Determining a thermal runaway probability of the battery to be tested       │
│              according to the activation energy data        │
└───────────────────────────────────────────────────────┘

FIG. 2

S310

Discharging or charging the battery to be tested based on a preset current, a preset test duration and at least one preset temperature

S320

Collecting, when the battery to be tested is discharged or charged, voltages of the battery to be tested according to a preset collection frequency, so as to obtain voltage data at each corresponding preset temperature

FIG. 3

S410

Obtaining, according to the voltage data under different preset temperatures, an SEI film initial voltage and an SEI film termination voltage at each preset temperature

S420

Obtaining the internal resistance data of the battery to be tested at each preset temperature according to the preset current, and the SEI film initial voltage and the SEI film termination voltage at the preset temperature

FIG. 4

S510

Obtaining voltage data of a battery to be tested under a preset condition

S520

Obtaining internal resistance data of the battery to be tested according to the preset condition and the voltage data

S530

Processing the internal resistance data based on a preset activation energy model to obtain activation energy data of the battery to be tested

S540

Determining a thermal runaway probability of the battery to be tested according to the activation energy data

S550

Obtaining the activation energy data of each battery to be tested in a battery pack

S560

Obtaining minimum activation energy data according to a plurality of activation energy data of the plurality of batteries to be tested

S570

Determining a thermal runaway probability of the battery pack according to the minimum activation energy data

FIG. 5

S610

Obtaining average activation energy data according to a plurality of activation energy data

S620

Performing ratio processing on the average activation energy data and each of the activation energy data to obtain a first ratio corresponding to each of the activation energy data

S630

Determining the thermal runaway probability of the battery pack according to the minimum activation energy data and the number of the activation energy data of which the first ratio is greater than a third threshold

FIG. 6

S710

Obtaining voltage data of a battery to be tested under a preset condition

S720

Obtaining internal resistance data of the battery to be tested according to the preset condition and the voltage data

S730

Processing the internal resistance data based on a preset activation energy model to obtain activation energy data of the battery to be tested

S740

Determining a thermal runaway probability of the battery to be tested according to the activation energy data

S750

Obtaining the activation energy data of the battery to be tested in a plurality of monitoring periods

S760

Performing ratio processing on the activation energy data of a previous monitoring period and the activation energy data of a current monitoring period to obtain a second ratio

S770

When the second ratio is greater than a fourth threshold, outputting a thermal runaway pre-warning of the battery to be tested corresponding to the current monitoring period

FIG. 7

```
                                                          ┌─ S811
┌─────────────────────────────────────────────────────────────────┐
│  Obtaining voltage data of the battery to be tested under         │
│                 different preset temperatures                     │
└─────────────────────────────────────────────────────────────────┘
                                ↓                         ┌─ S812
┌─────────────────────────────────────────────────────────────────┐
│     Obtaining an SEI film initial voltage at each preset          │
│                       temperature                                 │
└─────────────────────────────────────────────────────────────────┘
                                ↓                         ┌─ S813
┌─────────────────────────────────────────────────────────────────┐
│   Obtaining an SEI film termination voltage at each preset        │
│                       temperature                                 │
└─────────────────────────────────────────────────────────────────┘
                                ↓                         ┌─ S814
┌─────────────────────────────────────────────────────────────────┐
│   Calculating an internal resistance of the SEI film at each      │
│                    preset temperature                             │
└─────────────────────────────────────────────────────────────────┘
                                ↓                         ┌─ S815
┌─────────────────────────────────────────────────────────────────┐
│  Performing linear fitting on the internal resistances of the     │
│  SEI film and corresponding preset temperatures to obtain an      │
│     activation energy of the battery to be tested                 │
└─────────────────────────────────────────────────────────────────┘
                                ↓                         ┌─ S816
┌─────────────────────────────────────────────────────────────────┐
│   Predicting and investigating, according to the activation       │
│   energy of a plurality of batteries to be tested in the same     │
│   battery pack, the batteries with higher risk of thermal         │
│              runaway in the battery pack                          │
└─────────────────────────────────────────────────────────────────┘
```

FIG. 8

S911

Obtaining voltage data of the battery to be tested under different preset temperatures

S912

Obtaining an SEI film initial voltage at each preset temperature

S913

Obtaining an SEI film termination voltage at each preset temperature

S914

Calculating an internal resistance of the SEI film at each preset temperature

S915

Performing linear fitting on the internal resistances of the SEI film and corresponding preset temperatures to obtain an activation energy of the battery to be tested

S916

Predicting a time and probability of thermal runaway occurring in the battery to be tested by comparing attenuation of the activation energy of the battery to be tested during use

FIG. 9

1

10

Battery pack

120

Battery to be tested

110

Processing device

FIG. 10